(19) Europäisches Patentamt
European Patent Office
Office européen des brevets

(11) EP 1 237 983 B1

(12) EUROPEAN PATENT SPECIFICATION

(45) Date of publication and mention of the grant of the patent:
**01.08.2007 Bulletin 2007/31**

(21) Application number: **01922067.2**

(22) Date of filing: **24.04.2001**

(51) Int Cl.:
***C08G 65/18*** (2006.01) ***C08G 59/68*** (2006.01)

(86) International application number:
**PCT/JP2001/003537**

(87) International publication number:
**WO 2001/083580 (08.11.2001 Gazette 2001/45)**

# (54) POLYMERIZABLE COMPOSITION, CURED MATERIAL THEREOF AND METHOD FOR MANUFACTURING THE SAME

POLYMERISIERBARE ZUSAMMENSETZUNG UND GEHÄRTETES HARZ DARAUS, VERFAHREN ZUR SEINER HERSTELLUNG

COMPOSITION POLYMERISABLE, MATERIAU DURCI CORRESPONDANT ET PROCEDE DE FABRICATION

(84) Designated Contracting States:
**AT BE CH CY DE DK ES FI FR GB GR IE IT LI LU MC NL PT SE TR**

(30) Priority: **28.04.2000 JP 2000130472**

(43) Date of publication of application:
**11.09.2002 Bulletin 2002/37**

(73) Proprietor: **Showa Denko K.K.**
**Tokyo 105-8518 (JP)**

(72) Inventors:
- **WATANABE, Takeo,**
  **CTRL R.LAB., SHOWA DENKO K.K.**
  **Chiba-shi, Chiba 267-0056 (JP)**
- **SATO, Takashi,**
  **CTRL RES. LAB., SHOWA DENKO K.K.**
  **Chiba-shi, Chiba 267-0056 (JP)**
- **TAGOSHI, Hirotaka,**
  **CTRL RES. LAB. SHOWA DENKO K.K.**
  **Chiba-shi, Chiba 267-0056 (JP)**

(74) Representative: **Strehl Schübel-Hopf & Partner**
**Maximilianstrasse 54**
**80538 München (DE)**

(56) References cited:
**EP-A- 0 897 710**
**DE-A- 19 647 848**
**GB-A- 2 310 211**
**US-A- 3 388 105**
**US-A- 3 457 193**
**US-A- 5 674 922**

- **PATENT ABSTRACTS OF JAPAN vol. 1999, no. 08, 30 June 1999 (1999-06-30) & JP 11 061034 A (KANSAI PAINT CO LTD), 5 March 1999 (1999-03-05)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 237 983 B1

## Description

### Technical Field

The present invention relates to a polymerizable composition which rapidly polymerizes under irradiation of an active energy ray such as ultraviolet light or an electron beam and/or under heat to provide a cured material, a method, for polymerizing the composition and a cured material obtained by polymerizing the composition.

### Background Art

Curing of a resin by an active energy ray such as ultraviolet light is favored with various characteristics such as, for example, a high curing rate, good workability due to the non-use of a solvent, and a requirement for an extremely low energy amount, and therefore this technique is playing a very important role in various fields such as wood coating, metal painting and printing. At the initial stage of development in these fields, studies were exclusively directed to ultraviolet light initiation radical polymerization of polyfunctional acrylates, unsaturated polyesters or the like, and various materials comprising these polyfunctional acrylates, unsaturated polyesters or the like have been heretofore used. Even at the present date, most studies are directed to ultraviolet light initiation radical polymerization. However, it is now recognized that photoinitiation ionic polymerization is also fairly promising in various applied fields. The photoinitiation ionic polymerization, in which various monomers can be used, has the possibility of providing cured materials having various chemical and physical properties, and therefore this technique is attracting attention.

The photocationic polymerizable composition comprises a photocationic polymerization initiator (photoacid generator) capable of decomposing, and thereby generating an acid under irradiation of an active energy ray such as ultraviolet light, and a compound capable of causing a polymerization reaction or a crosslinking reaction by the generated acid. The development thereof is exclusively directed to epoxy resins having an oxirane ring which is a 3-membered cyclic ether, and the photocurable epoxy resins are known to have excellent properties in adhesion, heat resistance and chemicals resistance. However, conventional photocurable epoxy resins have a problem in that their photocuring rates are very low. Therefore, improving the curing rate while maintaining the properties of the epoxy resin is required.

A polyfunctional oxetane monomer comprising, as its polymerizable group, more than one oxetane ring, i.e. four-membered cyclic ethers, per molecule is reported to have photocurability equal to or higher than that of the corresponding polyfunctional epoxides (see, Journal of Macromolecular Science, Vol. A 29, No. 10, page 915 (1992); ibid., Vol. 30, Nos. 2 & 3, page 173; ibid., Vol. 30, Nos. 2 & 3, page 189 (1993)). Also, a photocurable composition comprising a polyfunctional oxetane monomer as a main component had been proposed (see, JP-A (Japanese Unexamined Patent Publication (Kokai)) No. 6-16804). The ultraviolet light curable resin using this polyfunctional oxetane monomer shows a high curing rate under irradiation by ultraviolet light as compared with epoxy resins, however, it encounters difficulties in application to uses such as coating on a material having low heat resistance, e.g. paper or plastic. Also, a higher photocuring rate is required.

The photocationic polymerization curable epoxy resin composition or the photocationic polymerization curable oxetane compound-containing resin composition may also be thermopolymerized by adding a heat cationic polymerization initiator which decomposes under heat to generate an acid, in place of adding a photocationic polymerization initiator. The photocationic polymerization initiator accelerates the ring-opening cationic polymerization of a cationic polymerizable compound under irradiation of an active energy ray. On the contrary, the heat cationic polymerization initiator accelerates the ring-opening cationic polymerization when the compound is externally heated or left at a room temperature, whereby this technique is particularly important in the field where the photocationic polymerization cannot be performed, for example, in curing a material having poor light transmittance or in manufacturing a thick cast molded article. Regarding heat cationic polymerization, see JP-A NO.11-246541, JP-A NO.11-106380 and JP-A NO.11-61034, etc. However, similarly to the photocationic polymerization, the curing rate of the heat cationic polymerization curable epoxy resin composition, the heat cationic polymerization curable oxetane compound-containing resin composition or mixture thereof is not sufficiently high, and therefore in order to obtain a cured material, a high temperature treatment for a long period of time or a large amount of heat cationic polymerization initiator is required. Accordingly, a composition satisfying productivity and profitability has not yet been obtained.

US-A-3457193 discloses a composition of 7,8-epoxyspiro[3.5]-2-oxanonane and boron trifluoride monoethylamine complex as a cationic initiator. The composition is cured under heat.

GB-A-2310211 discloses a composition comprising a resin having an oxetane group and an epoxy group within a single molecule. Furthermore, this document discloses the use of acid-generation type cationic polymerisation initiators for mixed oxetane-epoxy systems.

U.S. Patent No.3,388,105 describes a technique of curing an alicyclic alkane, having an oxetanyl group and

an epoxy group within the same molecule, by addition-reacting it under heat with a carboxyl group-containing compound. However, it is not known whether this alicyclic alkane can exhibit very high activity (curability) in the cationic

ring-opening polymerization.

Disclosure of the Invention

Under these circumstances, the present invention has been accomplished, and the object of the present invention is to provide a cationic polymerizable composition capable of exhibiting high activity (rapid polymerizability, rapid curability) under irradiation of an active energy ray and/or under heat.

As a result of extensive investigations to solve the above-described problems, the present inventors have found that a polymerizable composition as defined in the claims exhibits high activity (rapid polymerizability, rapid curability) in the cationic ring-opening polymerization under irradiation of an active energy ray and/or under heat, and at the same time, found that the polymerization product thereof (cured material) has good properties. The present invention has been accomplished based on these findings.

More specifically, the present invention relates to a polymerizable composition, a cured material obtained by polymerizing the composition and a method for manufacturing the cured material, described in the followings (1) to (22).

(1) A polymerizable composition comprising (a) a compound represented by formula (1):

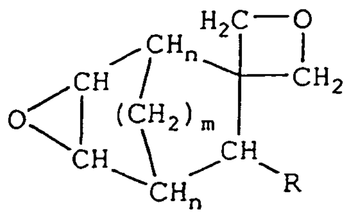

(1)

wherein R represents a hydrogen atom or a methyl group, m represents an integer of 0 to 2, and n is 2 when m is 0 and otherwise n is 1, and (b) a compound capable of generating an acid under irradiation of an active energy ray and/or under heat, and thereby initiating the cationic polymerization, wherein said compound (b) is one or more compound selected from the group consisting of sulfonium salts, iodonium salts and diazonium salts, a compound capable of initiating cationic polymerization under irradiation of the active energy ray and/or under heat.

(2) The polymerizable composition according to (1), wherein said alicyclic alkane (a) is 7,8-epoxy-2-oxa-5-methyl-spiro[3.5]nonane.

(3) The polymerizable composition according to (1), which comprises a compound (c) that can be cationic polymerized by said compound (b), wherein said compound (c) is other than said compound (a).

(4) The polymerizable composition according to (3) wherein at least one of said compound (c) is a compound (c-1) having one or more epoxy group that can be cationic polymerized by said compound (b).

(5) The polymerizable composition according to (3), wherein at least one of said compound (c) is a compound (c-2) having one or more oxetanyl group that can be cationic polymerized by said compound (b).

(6) The polymerizable composition according to (1), wherein said alicyclic alkane (a) is blended in an amount of 5 to 100 mass % based on the total mass of the polymerizable composition minus the mass of said compound (b).

(7) The polymerizable composition according to (4), wherein said compound (c-1) is blended in an amount of 5 to 95 mass % based on the total mass of the polymerizable composition minus the mass of said compound (b).

(8) The polymerizable composition according to (5), wherein said compound (c-2) is blended in an amount of 5 to 95 mass % based on the total mass of the polymerizable composition minus the mass of said compound (b).

(9) A cured material obtained by polymerizing a polymerizable composition comprising (a) a compound represented by formula (1):

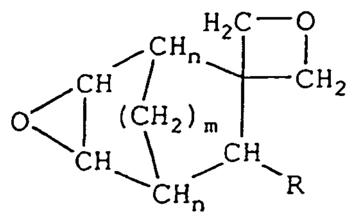

(1)

wherein R represents a hydrogen atom or a methyl group, m represents an integer of 0 to 2, and n is 2 when m is 0 and otherwise n is 1, and (b) a compound capable of generating an acid under irradiation of an active energy ray and/or under heat, and thereby initiating the cationic polymerization, wherein said compound (b) is one or more compound selected from the group consisting of sulfonium salts, iodonium salts and diazonium salts, under irradiation of an active energy ray and/or under heat wherein said compound (b) is one or more compound selected from the group consisting of sulfonium salts, iodonium salts and diazonium salts.

(10) The cured material according to (9), wherein said alicyclic alkane (a) is 7,8-epoxy-2-oxa-5-methylspiro[3.5] nonane.

(11) The cured material according to (10), which comprises a compound (c) that can be cationic polymerized by said compound (b), wherein said compound (c) is other than said compound (a).

(12) The cured material according to (11), wherein at least one of said compound (c) is a compound (c-1) having one or more epoxy group that can be cationic polymerized by said compound (b).

(13) The cured material according to (11), wherein at least one of said compound (c) is a compound (c-2) having one or more oxetanyl group that can be cationic polymerized by said compound (b).

(14) The cured material according to (9), wherein said alicyclic alkane (a) is blended in an amount of 5 to 100 mass% based on the total mass of the polymerizable composition minus the mass of said compound (b).

(15) The cured material according to (12), wherein said compound (c-1) is blended in an amount of 5 to 95 mass % based on the total mass of the polymerizable composition minus the mass of said compound (b).

(16) The cured material according to (13), wherein said compound (c-2) is blended in an amount of 5 to 95 mass % based on the total mass of the polymerizable composition minus the mass of said compound (b).

(17) A method for manufacturing a cured material from a polymerizable composition comprising (a) a compound represented by formula (1):

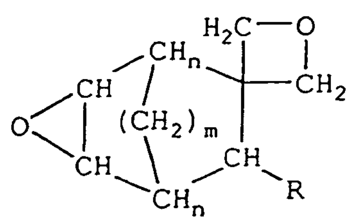

(1)

wherein R represents a hydrogen atom or a methyl group, m represents an integer of 0 to 2, and n is 2 when m is 0 and otherwise n is 1, and (b) a compound capable of generating an acid under irradiation of an active energy ray and/or under heat, and thereby initiating the cationic polymerization, wherein said compound (b) is one or more compound selected from the group consisting of sulfonium salts, iodonium salts and diazonium salts, under irradiation of the active energy ray and/or under heat, said method comprising initiating the polymerization under irradiation of an active energy ray and/or under heat.

(18) The method for manufacturing the cured material according to (17), comprising initiating the polymerization under irradiation of an active energy ray.

(19) The method according to (18), wherein said active ray is ultraviolet light.

(20) The method for manufacturing the cured material according to (17) comprising initiating the polymerization under heat.

(21) The method for manufacturing the cured material according to (17) comprising initiating the polymerization under irradiation of an active energy ray and then heating the composition.

(22) The method according to (21), wherein said active ray is ultraviolet light.

Best Mode for Carrying Out the Invention

The present invention is described in detail below.

The present invention relates to a polymerizable composition comprising (a) an alicyclic alkane having at least one oxetanyl group and at least one epoxy group within the same molecule and (b) a compound capable of initiating cationic polymerization under irradiation of an active energy ray and/or under heat, and also relates to a method for polymerizing the composition and a cured material of the composition.

Examples of the alicyclic alkane (a) having at least one oxetanyl group and at least one epoxy group within the same molecule for use in the present invention include 7,8-epoxy-2-oxa-5-methylspiro[3.5]nonane, 6,7-epoxy-2-oxaspiro[3.5]nonane, 7,8-epoxy-2-oxa-5-methylspiro[3.6]decane, 5,6-epoxy-2-oxaspiro[3.6]decane, spiro[5,6-epoxynorbornane-2,3'-oxetane] and spiro[5,6-epoxy-3-methylnorbornane-2,3'-oxetane. Among these, preferred are 7,8-epoxy-2-oxa-5-methylspiro[3.5]nonane, 6,7-epoxy-2-oxaspiro[3.5]nonane and spiro[5,6-epoxynorbornane-2,3'-oxetane].

Alicyclic alkanes having at least one oxetanyl group and at least one epoxy group within the same molecule can be easily synthesized by a known method described, for example, in U.S. Patent 3,388,105.

Alicyclic alkanes (a) having at least one oxetanyl group and at least one epoxy group within the same molecule can be used individually or as a mixture of two or more thereof.

The compound (a) is suitably blended in an amount of from 5 to 100 mass % (in the case of using two or more compounds (a), the total amount thereof) based on the total weight of the polymerizable composition of the present invention minus the weight of the compound (b) capable of initiating cationic polymerization under irradiation of an active energy ray and/or under heat.

The compound (b) capable of initiating cationic polymerization under irradiation of an active energy ray and/or under heat for use in the present invention is a compound which is subjected to a conversion under heat or under irradiation of an active energy ray such as ultraviolet light, and thereby generates the substance capable of initiating the cationic polymerization, i.e. an acid. Accordingly, the compound (b) is one of a cationic polymerization initiator and is called an "acid generator" in the art. The compound (b) is hereinafter referred to as an acid generation-type cationic polymerization initiator.

The acid generation-type cationic polymerization initiator is added in order to accelerate the ring-opening cationic polymerization of both the oxetanyl group and the epoxy group in the alicyclic alkane (a) having at least one oxetanyl group and at least one epoxy group within the same molecule of the present invention, under heat or irradiation with light such as ultraviolet light, and to allow smooth curing of the curable material or coating to proceed.

The acid generation-type cationic polymerization initiator as used in the present invention is a compound which is subjected to a conversion under heat or under irradiation of an active energy ray such as ultraviolet light and thereby generates an acid capable of initiating the cationic polymerization, and excludes compounds originally in an acid form, such as carboxylic acid.

Examples of the acid generation-type cationic polymerization initiator include known sulfonium salts, iodonium salts, and diazonium salts. Specific examples thereof are described below, however, the present invention is not limited to these compounds.

Examples of the sulfonium salt-based acid generation-type cationic polymerization initiator include bis[4-(diphenylsulfonio)phenyl]sulfide bishexafluorophosphate, bis[4-(diphenylsulfonio)phenylјsulfide bishexafluoro-antimonate, bis[4-(diphenylsulfonio)phenyl]sulfide bistetrafluoroborate, bis[4-(diphenylsulfonio)phenyl]-sulfide tetrakis(pentafluorophenyl)borate, diphenyl-4-(phenylthio)phenylsulfonium hexafluorophosphate, diphenyl-4-(phenylthio)phenylsulfonium hexafluoroantimonate, diphenyl-4-(phenylthio)phenylsulfonium tetrafluoroborate, diphenyl-4-(phenylthio)phenylsulfonium tetrakis(pentafluorophenyl)borate, triphenylsulfonium hexafluorophosphate, triphenylsulfonium hexafluoroantimonate, triphenylsulfonium tetrafluoroborate, triphenylsulfonium tetrakis(pentafluorophenyl)borate, bis[4-(di(4-(2-hydroxyethoxy))phenyl-sulfonio)phenyl]sulfide bishexafluorophosphate, bis[4-(di(4-(2-hydroxyethoxy))phenylsulfonio)phenyl] sulfide bis-hexafluoroantimonate, bis[4-(di(4-(2-hydroxyethoxy))-phenylsulfonio)phenyl]sulfide bistetrafluoroborate and bis[4-(di(4-(2-hydroxyethoxy))phenylsulfonio)phenyl]sulfide tetrakis(pentafluorophenyl)borate.

Examples of the iodonium salt-based acid generation-type cationic polymerization initiator include diphenyliodonium hexafluorophosphate, diphenyliodonium hexafluoroantimonate, diphenyliodonium tetrafluoroborate, diphenyliodonium tetrakis(pentafluorophenyl)borate, bis-(dodecylphenyl)iodonium hexafluorophosphate, bis(dodecylphenyl)iodonium hexafluoroantimonate, bis (dodecylphenyl)-iodonium tetrafluoroborate, bis(dodecylphenyl)iodonium tetrakis (pentafluorophenyl)borate, 4-methylphenyl-4-(l-methylethyl)phenyliodonium hexafluorophosphate, 4-methylphenyl-4-(1-methylethyl)phenyliodonium hexafluoroantimonate, 4-methylphenyl-4-(1-methylethyl)phenyliodonium tetrafluoroborate and 4-methylphenyl-4-(1-methylethyl)phenyliodonium tetrakis(pentafluorophenyl)borate.

Examples of the diazonium salt-based acid generation-type cationic polymerization initiator include phenyldiazonium hexafluorophosphate, phenyldiazonium hexafluoroantimonate, phenyldiazonium tetrafluoroborate and phenyldiazonium tetrakis(pentafluorophenyl)borate.

Among these, sulfonium salt-based and iodonium salt-based acid generation-type cationic polymerization initiators are preferred in view of curing rate, stability and profitability. Examples of the commercially available product include SP-150, SP-170, CP-66 and CP-77 produced by Asahi Denka Kogyo; CYRACURE-UVI-6990 and UVI-6974 produced by Union Carbide; CI-2855. and CI-2639 produced by Nippon Soda; San-Aid SI-60 produced by Sanshin Kagaku Kogyo K.K.; IRGACURE 261 ((2,4-cyclopentadien-1-yl) [(1-methylethyl)benzene]-Fe(II) hexafluorophosphate) produced by Ciba Specialty Chemicals; and RHODORSIL 2074 (4-methylphenyl-4-(1-methylethyl)phenyliodonium tetrakis-(pentafluorophenyl)borate) produced by Rhone Poulenc.

The acid generation-type cationic polymerization initiator may be selected from the above-described materials and these materials may be used individually or in a combination of two or more thereof. The suitable range of the amount of the acid generation-type cationic polymerization initiator is not critical, but is preferably used in an amount of 0.05 to 25 parts by mass, preferably from 1 to 10 parts by mass, based on the total amount (100 parts by mass) of the polymerizable compounds (namely, the alicyclic alkane (a) having at least one oxetanyl group and at least one epoxy group within the same molecule and the compound (c)) which can be cationic polymerized by the compound (b) capable of initiating cationic polymerization under irradiation of an active energy ray and/or under heat. If adding it in an amount less than 0.05 parts by mass, poor sensitivity results, and a tremendously large amount of light irradiation energy or a high-temperature treatment over an extended time period will be required for curing. On the other hand, even though adding it in an amount more than 25 parts by mass, the sensitivity will not increase and this is not preferred also in view of the profitability. Moreover, the amount of the initiator remaining in the coating as an uncured component will increase, and thereby the physical properties of the cured product may deteriorate.

For the compound (c-1) having an epoxy group for use in the present invention, an epoxy compound commonly known and used can be employed, and this compound is not particularly limited as long as it has one or more epoxy group within one molecule.

Specific examples of the compound which can be used include bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, cresol novolak epoxy resin and triglycidyl isocyanurate.

Examples of the alicyclic epoxy compound include (3,4-epoxycyclohexyl)methyl-3',4'-epoxycyclohexyl carboxylate, 2-(3,4-epoxycyclohexyl-5,5-spiro-3,4-epoxy)cyclohexane-meta-dioxane, bis(3,4-epoxycyclohexylmethyl) adipate, vinylcyclohexene oxide, 4-vinylepoxycyclohexane, bis(3,4-epoxy-6-methylcyclohexylmethyl) adipate, 3,4-epoxy-6-methylcyclohexyl-3',4'-epoxy-6'-methylcyclohexane carboxylate, methylenebis(3,4-epoxycyclohexane), dicyclopentadiene diepoxide, di(3,4-epoxycyclohexylmethyl) ether of ethylene glycol, and ethylenebis(3,4-epoxycyclohexane carboxylate).

Other examples include dioctyl epoxyhexahydrophthalate, di-2-ethylhexyl epoxyhexahydrophthalate, 1,4-butanedioldiglycidyl ether, 1,6-hexanedioldiglycidyl ether, glycerol triglycidyl ether, trimethylolpropane triglycidyl ether, polyethylene glycol diglycidyl ether, polypropylene glycol diglycidyl ether; polyglycidyl ethers of a polyether polyol obtained by adding one or more alkylene oxide to an aliphatic polyhydric alcohol, such as ethylene glycol, propylene glycol and glycerol; diglycidyl ethers of aliphatic long-chained dibasic acid; monoglycidyl ethers of aliphatic higher alcohol; butyl glycidyl ether, phenyl glycidyl ether, cresol glycidyl ether, nonylphenyl glycidyl ether, glycidyl methacrylate; monoglycidyl ethers of phenol, cresol, butylphenol or polyether alcohol obtained by adding an alkylene oxide thereto; glycidyl esters of higher fatty acid; epoxidated soybean oil; butyl epoxystearate, octyl epoxystearate, epoxidated linseed oil and epoxidated polybutadiene.

These compounds (c-1) having one or more epoxy group within the molecule can be used individually or as a mixture of two or more thereof.

The compound (c-1) can be blended in an amount of 5 to 95 mass % (in the case of using two or more compounds (c-1), the total amount thereof) based on the total weight of the polymerizable composition of the present invention minus the weight of the compound (b) capable of initiating cationic polymerization under irradiation of an active energy ray and/or under heat.

The compound (c-2) having one or more oxetanyl group within the molecule is described below. The compound

(c-2) having one or more oxetanyl group is used for the purpose of adjusting the viscosity of the entire polymerizable composition according to its use end and also imparting effects considered to be ascribable to the oxetane compound, namely, water resistance or a reduction in curing shrinkage.

Specific examples thereof include trimethylene oxide, 3,3-dimethyloxetane, 3,3-dichloromethyloxetane, 3-ethyl-3-phenoxymethyloxetane, 3-ethyl-3-hydroxymethyloxetane (EOXA, trade name, produced by Toa Gosei), bis[(3-ethyl-3-oxetanylmethoxy)methyl]benzene (also called xylylene dioxetane; XDO, trade name, produced by Toa Gosei), tri[(3-ethyl-3-oxetanylmethoxy)methyl]benzene, bis[(3-ethyl-3-oxetanylmethoxy)methylphenyl]ether, (3-ethyl-3-oxetanylmethoxy)oligodimethylsiloxane, and compounds containing a multifunctional oxetane ring having a high molecular weight, specifically, oxetane oligomer (Oligo-OXT, trade name, produced by Toa Gosei)

Examples of the compound having an alicyclic structure other than an oxetane ring within the same compound include 2-oxaspiro[3.5]nonane, 7-methyl-2-oxaspiro[3.5]nonane, spiro[adamantane-2,3'-oxetane], spiro[bicyclo[2.2.1]heptane-2,3'-oxetane], spiro[bicyclo[2.2.2]octane-2,3'-oxetane], spiro[7-oxabicyclo[2.2.1]heptane-2,3'-oxetane], 2-oxaspiro[3.5]non-6-ene, 5-methyl-2-oxaspiro[3.5]non-6-ene, spiro[bicyclo[2.2.1]hept-5-ene-2,3'-oxetane], spiro[3-methylbicyclo[2.2.1]hept-5-ene-2,3'-oxetane], 5-methyl-2-oxaspiro[3.5]nonane and spiro[3-methylbicyclo[2.2.1]heptane-2,3'-oxetane].

These compounds (c-2) having one or more oxetanyl group can be used individually or as a mixture of two or more thereof.

The compound (c-2) can be blended in an amount of 5 to 95 mass % (in the case of using two or more compounds (c-2) in combination, the total amount thereof) based on the total weight of the polymerizable composition of the present invention minus the weight of the compound (b) capable of initiating cationic polymerization under irradiation of an active energy ray and/or under heat.

In the present invention, a cationic polymerizable monomer described below can also be added to the polymerizable composition. This cationic polymerizable monomer is classified into the compound (c) that causes a polymerization reaction or crosslinking reaction by the acid generated from the acid generation-type cationic polymerization initiator, but other than the compound (c-1) or (c-2). Examples thereof include oxolane compounds such as tetrahydrofurane, 2,3-dimethyl-tetrahydrofurane; cyclic acetal compounds such as trioxan, 1,3-dioxolane and 1,3,6-trioxancyclooctane; cyclic lactone compounds such as β-propiolactone and ε-caprolactone; thiirane compounds such as ethylenesulfide, 1,2-propylenesulfide and thioepichlorohydrin; thiethane compounds such as 3,3-dimethylthiethane; vinyl ether compounds such as ethylene glycol divinyl ether, triethylene glycol divinyl ether, trimethylol propane trivinyl ether; spiroorthoester compounds, a reaction product of an epoxy compound with lactone; ethylenically unsaturated compounds such as vinylcyclohexane, isobutylene and polybutadiene; cyclic ether compounds; cyclic thioether compounds; and vinyl compounds.

These cationic polymerizable monomers can be added individually or in a combination of two or more thereof.

In polymerizing the polymerizable composition of the present invention by an ultraviolet light which is one kind of active energy rays, a sensitizer may also be used for improving the polymerization rate. Examples of the sensitizer used to this purpose include pyrene, perylene, 2,4-diethylthioxanthone, 2,4-dimethylthioxanthone, 2,4-dichlorothioxanthone and phenothiazine. In the case of using a sensitizer, the sensitizer is preferably used in an amount of 0.1 to 100 parts by mass per 100 parts by mass of photoacid generation-type cationic polymerization initiator.

The polymerizable composition of the present invention may also contain an organic solvent. The organic solvent is used for the purpose of adjusting the viscosity according to the use or the coating method or in the case where the polymerizable composition is solid, for dissolving and diluting the polymerizable composition and thereby enabling the coating of the polymerizable composition in a liquid form. Specific examples of the organic solvent which can be used include known solvents such as acetone, hexane, ethyl acetate, diethyl ether, ethyl methyl ketone, cyclohexane, tetrahydrofurane, toluene, xylene, tetramethylbenzene, petroleum ether, petroleum naphtha and solvent naphtha; ethylene glycol monoalkyl ethers and acetates thereof; diethylene glycol mono- or di-alkyl ethers; propylene glycol monoalkyl ethers and acetates thereof; dipropylene glycol mono- or di-alkyl ethers; methyl carbitol, butyl carbitol, butyl cellosolve acetate and carbitol acetate.

These organic solvents can be used individually or in combination of two or more thereof. The amount of this organic solvent used can be appropriately selected according to the use end or the coating method.

In the case of applying the polymerizable composition of the present invention to uses where adhesion, hardness or the like is required, a commonly known inorganic filler may be used, if desired, for the purpose of improving various properties, and examples thereof include barium sulfate, barium titanate, powdered silicon oxide, finely powdered silicon oxide, amorphous silica, talc, clay, magnesium carbonate, calcium carbonate, aluminum oxide, aluminum hydroxide and mica powder. Furthermore, if desired, commonly known additives may also be added, and examples thereof include a coloring agent such as Phthalocyanine Blue, Phthalocyanine Green, Iodine Green, Disazo Yellow, Crystal violet, titanium oxide, carbon black and naphthalene black; a silicone-type, fluorine-type or polymer-type defoaming agent and/or leveling agent; and an adhesion-imparting agent such as imidazole type, thiazole type, triazole type or silane coupling agent.

Polymerization Method for Polymerizable Composition of the Present Invention:

The polymerizable composition of the present invention can be polymerized (cured) under irradiation of an active energy ray and/or under heat. The term "active energy ray" as used herein can be ultraviolet light; x-rays, an electron beam, y rays or the like. In the case of using ultraviolet light, examples of the light source include a metal halide lamp, a mercury arc lamp, a xenon arc lamp, a fluorescent lamp, a carbon arc lamp, a tungsten-halogen duplicate lamp and sunlight.

The irradiation conditions in the polymerization (curing) under irradiation of an active energy ray may be appropriately selected according to the light transmission which varies depending on the film thickness of the polymerizable composition (the object to be cured) or the blending of a pigment or the like. In the case of curing a coating having a thickness of about 20 μm using ultraviolet light, the dose may be from 1 to 2,000 mJ/cm$^2$, preferably from 10 to 1,000 mJ/cm$^2$. Furthermore, when the object to be cured contains a solvent, light can be irradiated after removing the solvent by heating or the like.

In the case of polymerization (curing) under heat, the conditions are generally a temperature of approximately from 50 to 400°C and a curing time of 5 seconds to 60 minutes, preferably approximately from 80°C to 250°C and from 10 seconds to 30 minutes.

After the irradiation of an active energy ray, if desired, the cured material may be heated. By this post-heating, the unreacted material remaining in the cured material may be reduced and the cure distortion generated in the cured material due to irradiation of an active energy ray may be relaxed. As a result, hardness of the cured material may improve and in the case of a coating, adhesion against the substrate to be coated may improve. This post-heating can be generally performed in an atmosphere temperature of 80 to 300°C for 5 seconds to 30 minutes.

The polymerizable composition of the present invention can be applied to substrates such as metal, rubber, plastic, paper, wood, glass, ceramic and concrete.

Examples of the use of the photosensitive resin composition of the present invention include a coating material, an adhesive, a sealing agent, a construction and building material, a laminate, electrical and electric parts, a photoresist, a solder resist, a layer insulating material for multilayer circuit boards, concrete structure repairing, a material for cast molding, a printing ink, a sealant, and a material for stereolithography.

Examples

The present invention is described in greater detail below by referring to the Examples and the Comparative Examples, however, the present invention should not be construed as being limited to these Examples. Unless otherwise indicated, the term "parts" used in Examples and Comparative Examples is "parts by mass".

Among the materials used in the Examples and the Comparative Examples, the commercially available products shown below were used in their original condition without passing through any purification.

EPIKOTE 828: bisphenol A-type epoxy resin, produced by Yuka Shell Epoxy K.K.; XDO: 1,4-bis[(3-ethyl-3-oxetanylmethoxy)methyl]benzene, produced by Toa Gosei; EPIKOTE 152: phenol · novolak type epoxy resin, produced by Yuka Shell Epoxy K.K.; KRM-2110: alicyclic base resin, produced by Asahi Denka Kogyo K.K.; SUN-AID SI-60L: $SbF_6$ type sulfonium salt cationic polymerization initiator, produced by Sanshin Kagaku Kogyo; UVI-6990: triaryl sulfonium hexafluorophosphate salt-type cationic polymerization initiator, produced by UCC.

The compounds which are not commercially available were chemically synthesized by the present inventors. That is, 7,8-epoxy-2-oxa-5-methylspiro[3.5]nonane and 6,7-epoxy-2-oxaspiro[3.5]nonane were synthesized by the present inventors with reference to U.S.Patent No.3,388,105. In particular, 7,8-epoxy-2-oxa-5-methylspiro[3.5]nonane was synthesized as below:

<Synthesis of 7,8-epoxy-2-oxa-5-methylspiro[3.5]nonane> 1) Synthesis of 6-methyl-3-cyclohexene-1,1-dimethanol

To a three-necked flask, 327 g of 2-methyl-4-cyclohexene-1-carboaldehyde, a Diels-Alder reaction product of butadiene and crotonaldehyde, 600 ml of methanol and 729 g of 37 % of formalin were charged, and then the temperature of this solution was raised to 60°C with stirring. Next, 252 g of KOH dissolved in 600 ml of distilled water was added dropwise thereto. After stirring for 7 hours, the reaction solution was concentrated under reduced pressure, which resulted in a residue with two phases. The oil phase concentrated to about 150 ml was washed with 300 ml of distilled water. After concentration under reduced pressure, 50 mg of 3,5-di(t-butyl)-4-hydroxytoluene (BHT) was added to the oil phase, and then vacuum distillation was carried out to yield 311 g (yield 82 %) of 6-methyl-3-cyclohexene-1,1-dimethanol as a colorless crystal.

2) Synthesis of 6-methyl-3-cyclohexene-1,1-dimethanol cyclic carbonate ester

To a three-necked flask, 310 g (1.99 mol) of 6-methyl-3-cyclohexene-1,1-dimethanol, 894 g of dimethylcarbonate (DMC) and 0.93 g of potassium carbonate were charged, and was refluxed at a temperature raised to 90°C for 4 hours. The reaction solution was cooled to room temperature, and potassium carbonate was filtered off. After adding 120 mg of BHT, the remaining DMC and methanol were removed at a reduced pressure of 2 kPa (15mmHg), and then vacuum distillation was cartried out to yield 326 g (yield 89.4 %) of 6-methyl-3-cyclohexene-1,1*dimethanol cyclic carbonate ester, which is in a form of colorless crystals at room temperature.

3) Synthesis of 2-oxa-9-methylspiro[3.5]non-6-ene

To a three-necked flask, 321.15 g of 6-methyl-3-cyclohexene-1,1-dimethanol cyclic carbonate ester, 642 mg (0.2 mass %) of BHT, 1.93 g of LiCl were charged, and then stirred with heating at 275°C using a mantle heater. The reaction product was immediately drained out of the reaction system at a reduced pressure of about 8kPa (60mmHg), and heating was continued until no efflux therefrom was observed. 600 mg of BHT was added to the product, and then vacuum distillation was carried out to yield 187 g (yield 71 %) of 2-oxa-9-methylspiro[3.5]non-6-ene as a transparent and colorless solution.

4) Synthesis of 7,8-epoxy-2-oxa-5-methylspiro[3.5]nonane

50 g of 2-oxa-9-methylspiro[3.5]non-6-ene was dissolved in 150 ml of dichloromethane, and charged into a reaction vessel. 93.7 g of m-chloroperbenzoic acid suspended in 400 ml of dichloromethane was added dropwise over 1 hour, while keeping the temperature of the reaction solution under 40°C. The crystallized m-chlorobenzoic acid was filtered off, and washed thoroughly with cold dichloromethane. 15.0 g of potassium hydroxide was charged to the organic phase, and after 30 minutes, the crystallized crystal was filtered off, and washed with cold dichloromethane. The organic phase was washed with 5 % of aqueous $NaHSO_4$, saturated saline, followed by concentration, to yield 38.1 g (yield. 73.7 %) of 7,8-epoxy-2-oxa-5-methylspiro[3.5]nonane in a colorless semi-solid form.

6,7-epoxy-2-oxaspiro[3.5]nonane was also synthesized by the present inventors with a similar procedure as above.

<Synthesis of 5-methyl-2-oxaspiro[3 5]nonane>

To a three-necked flask, 474 g of 2-methylcyclohexane-1,1-dimethanol, 405 g of dimethylcarbonate and 1.4 g of potassium carbonate were charged, heated in an oil bath at a temperature of 100°C with stirring, and the reaction was allowed to proceed for 14 hours while distilling out the formed methanol from the reaction system under atmospheric pressure. Finally, the pressure within the reaction vessel was reduced to 10 mmHg, yielding a carbonate ester in a yield of 95%.

The resulting cyclic carbonate ester was heated to 250°C, and the reaction was allowed to proceed for 10 hours while distilling out the formed carbonic acid gas from the reaction system via the top of a cooling instrument. This reaction solution was subjected to a distillation purification to yield 230 g of 5-methyl-2-oxaspiro[3.5]nonane.

<Synthesis of spiro[5,6-epoxynorbornane-2,3'-oxetane]>

This compound was synthesized by the present inventors in exactly the same manner as the synthesis of 7,8-epoxy-2-oxa-5-methylspiro[3.5]nonane, except for using a Diels-Alder reaction product of cyclopentadiene and acroleln in place of the Diels-Alder reaction product of butadiene and crotonaldehyde. Method for Evaluating Polymerizability and Physical Properties of Cured Material:

In the evaluation of polymerizability and physical properties of cured material, the reaction conversion, the surface hardness and the pencil scratch value of cured material were determined and used as indices. Specifically, the values were determined by the following operations.

1) Reaction Conversion

The reaction conversion was calculated from the variation of infrared absorption spectrum before and after the polymerization of the polymerizable composition coated on a silicon wafer to a thickness of 10 μm.

The infrared absorption spectrum was measured by the transmission method using an FTIR measuring apparatus (Fourier transformation infrared spectrophotometer, Model VALOR-III, manufactured by Nihon Bunko K.K.).

The reaction conversion was determined from the amount of the variation, before and after the irradiation, in the absorbance of the characteristic absorption peak in the infrared absorption spectrum, more specifically, for oxetanyl

group, the characteristic absorption peak at 980 $cm^{-1}$; for alicyclic epoxy group, the characteristic absorption peak at from 789 to 798 $cm^{-1}$; and for glycidyl group, the characteristic absorption peak at 773 $cm^{-1}$, respectively, according to the following formula:

Conversion = (1 - absorbance of characteristic absorption peak after irradiation/absorbance of characteristic absorption peak before irradiation) × 100 (%)

In Examples 6 to 8, the average of reaction conversion values of the oxetanyl group and the epoxy group present within the same molecule was used as the conversion. In Comparative Examples 3 to 8, the conversion was calculated from the peak of characteristic absorption (glycidyl group in EPIKOTE 828, oxetanyl group in XDO, and alicyclic epoxy group in KRM-2110) of the material used for comparison.

2) Surface Hardness

The surface hardness of the cured materials were measured using a hardness tester manufactured by Colman Co. (GYZJ934-1). The measurement temperature was 23°C.

3) Pencil Scratch value of Cured Material

The cured coatings of the polymerizable compositions on silicon wafers were measured in accordance with JIS K5400.

Thermopolymerization of Composition:

(Example 1)

To 100 parts of 7,8-epoxy-2-oxa-5-methylspiro[3.5]nonane, 5 parts of an acid generation-type cationic polymerization initiator "SUN-AID SI-60L, produced by Sanshin Kagaku Kogyo K.K." was added and thoroughly stirred to obtain a thermopolymerizable composition. Laminates, each comprising a 2 mm-thick glass plate, wherein a 2 mm-thick rubber spacer having a 5 cm diameter bored hole is placed thereon and a thermopolymerizable composition being poured into the bored hole, and another glass plate laminated to the former plate in order to prevent the entry of air, were provided. Two units of this device were prepared and left standing in an oven at 120°C. One was taken out from the oven after 10 minutes and another was taken out after 30 minutes to obtain cured materials having a diameter of 5 cm and a thickness of 2 mm. After the cured materials had cooled to room temperature, the temperature was adjusted to 23°C and the surface hardness of each cured material with a curing time of 10 minutes or 30 minutes was measured. The results obtained are shown in Table 1.

(Example 2)

The operation was performed in exactly the same manner as in Example 1 except for using 6,7-epoxy-2-oxaspiro[3.5]nonane in place of 7,8-epoxy-2-oxa-5-methylspiro[3.5]nonane, and then the surface hardness of each cured material was measured. The results obtained are shown in Table 1.

(Example 3)

The operation was performed in exactly the same manner as in Example 1 except for using spiro[5,6-epoxynorbornane-2,3'-oxetane] in place of 7,8-epoxy-2-oxa-5-methylspiro[3.5]nonane, and then the surface hardness of each cured material was measured. The results obtained are shown in Table 1.

(Example 4)

The operation was performed in exactly the same manner as in Example 1 except for using a mixture of 90 parts of 7,8-epoxy-2-oxa-5-methylspiro[3.5]nonane and 10 parts of EPIKOTE 828 (produced by Yuka Shell Epoxy K.K.)

in place of 100 parts of 7,8-epoxy-2-oxa-5-methyl spiro[3.5]nonane, and then the surface hardness of each cured material was measured. The results obtained are shown in Table 1.

(Example 5)

The operation was performed in exactly the same manner as in Example 1 except for using a mixture of 80 parts of 7, 8-epoxy-2-oxa-5-methylspiro[3.5]nonane, 10 parts of EPIKOTE 828 (produced by Yuka Shell Epoxy K.K.) and 10 parts of 5-methyl-2-oxaspiro[3.5]nonane in place of 100 parts of 7,8-epoxy-2-oxa-5-methylspiro[3.5]nohane, and then the surface hardness of each cured material was measured. The results obtained are shown in Table 1.

(Example 6)

The operation was performed in exactly the same manner as in Example 1 except for using a mixture of 10 parts of 7,8-epoxy-2-oxa-5-methylspiro[3.5]nonane and 90 parts of EPIKOTE 152 (produced by Yuka Shell Epoxy K.K.) in place of 100 parts of 7,8-epoxy-2-oxa-5-methyl spiro[3.5]nonane, and then the surface hardness of each cured material was measured. The results obtained are shown in Table 1.

(Comparative Examples 1 and 2)

The operations were performed in exactly the same manner as in Example 1 except for using a heat polymerizable composition having the formulations shown in Table 1, and then the surface hardness of each cured material was measured. The results obtained are shown in Table 1.

As is apparent from Table 1, the polymerizable compositions of the present invention in Examples 1 to 5 achieved the final hardness with heating for about 10 minutes, and this reveals that each composition had rapidly polymerized and cured.

Also, it is seen from the comparison between Example 6 and Comparative Example 2 that the curing rate of epoxy resin can be improved by blending about 10 parts by mass of the alicyclic alkane (a) having at least one oxetanyl group and at least one epoxy group within the molecule of the present invention, into the epoxy resin.

Table 1

| Blending of Polymerizable Composition and Surface Hardness of Cured Material | | | | | | | | |
|---|---|---|---|---|---|---|---|---|
| Name of Compound | Examples | | | | | | Comparative Examples | |
| | 1 | 2 | 3 | 4 | 5 | 6 | 1 | 2 |
| 7,8-epoxy-2-oxa-5-methylspiro[3.5]nonane | 100 | 0 | 0 | 90 | 80 | 10 | 0 | 0 |
| 6,7-epoxy-2-oxaspiro[3.5]nonane | 0 | 100 | 0 | 0 | 0 | 0 | 0 | 0 |
| Spiro[5,6-epoxynorbornane-2,3'-oxetane] | 0 | 0 | 100 | 0 | 0 | 0 | 0 | 0 |
| 5-Methyl-2-oxaspiro[3.5]nonane | 0 | 0 | 0 | 0 | 10 | 0 | 0 | 0 |
| EPIKOTE 828 | 0 | 0 | 0 | 10 | 10 | 0 | 0 | 0 |
| XDO | 0 | 0 | 0 | 0 | 0 | 0 | 100 | 0 |
| EPIKOTE 152 | 0 | 0 | 0 | 0 | 0 | 90 | 0 | 100 |
| SUN-AID SI-60L | 5 | 5 | 5 | 5 | 5 | 5 | 5 | 5 |
| Surface hardness (hard) after heat-curing for 10 minutes | 20 | 18 | 22 | 20 | 18 | 20 | 0 | 5 |
| after heat-curing for 30 minutes | 25 | 24 | 27 | 25 | 24 | 25 | 2 | 10 |

Photopolymerization of Composition

(Example 7)

To 100 parts of 7,8-epoxy-2-oxa-5-methylspiro[3.5]nonane, 5 parts of photoacid generation-type cationic polymerization initiator "UVI-6990" produced by Union Carbide K.K. was added and thoroughly stirred to obtain a photopolymerizable composition.

Subsequently, this composition was coated on a silicon wafer to a thickness of 10 μm and the conversion of the reactive groups was determined following the irradiation with a high-pressure mercury lamp at 1.45 mW/cm$^2$ for 10 seconds and for 30 seconds.

Furthermore, in accordance with the measurement method of 3) Pencil Scratch Value above, the pencil scratch value of the cured coating on the silicon wafer obtained by the irradiation for 30 seconds was measured.

The results obtained are shown together in Table 2.

(Example 8)

The operation was performed in exactly the same manner as in Example 7 except for using a mixture of 90 parts of 7,8-epoxy-2-oxa-5-methylspiro[3.5]nonane and 10 parts of EPIKOTE 828 (produced by Yuka Shell Epoxy K.K.) in place of 100 parts of 7,8-epoxy-2-oxa-5-methylspiro[3.5]nonane, and then the conversion and the pencil scratch value were measured. The results obtained are shown in Table 2.

(Example 9)

The operation was performed in exactly the same manner as in Example 7 except for using a mixture of 50 parts of 7,8-epoxy-2-oxa-5-methylspiro[3.5]nonane and 50 parts of EPIKOTE 828 (produced by Yuka Shell Epoxy K.K.) in place of 100 parts of 7,8-epoxy-2-oxa-5-methylspiro[3.5]nonane, and then the conversion and the pencil scratch value were measured. The results obtained are shown in Table 2.

From the results of Examples 7 to 9, it was demonstrated that the conversions of oxetanyl group and alicyclic epoxy group were more improved, and a more rapid curing rate was achieved by blending an epoxy compound as a constituent element of the composition of the present invention, to the alicyclic alkane having at least one oxetanyl group and at least one epoxy group within the same molecule.

(Comparative Examples 3 to 5)

The operation was performed in exactly the same manner as in Example 7 except for using a photopolymerizable composition having formulations shown in Table 2, and the conversions and the pencil scratch values were measured. The results obtained are shown in Table 2.

As is apparent from Table 2, following the light irradiation, the reactive groups of the polymerizable compositions of the present invention in Examples 7 to 9 decreased rapidly, namely, they polymerized rapidly: as compared with the Comparative Examples 3 to 5, revealing that the compositions can be polymerized and cured within a short period of time.

[Table 2]

| Blending and Conversion of Polymerizable Composition and Pencil Scratch Value of Cured Material | | | | | | |
|---|---|---|---|---|---|---|
| | Examples | | | Comparative Examples | | |
| Name of Compound | 7 | 8 | 9 | 3 | 4 | 5 |
| 7,8-epoxy-2-oxa-5-methylspiro[3.5] nonane | 100 | 90 | 50 | 0 | 0 | 0 |
| EPIKOTE 828 | 0 | 10 | 50 | 0 | 0 | 0 |
| XDO | 0 | 0 | 0 | 100 | 0 | 0 |
| EPIKOTE 152 | 0 | 0 | 0 | 0 | 100 | 0 |
| KRM-2110 | 0 | 0 | 0 | 0 | 0 | 100 |
| UVI-6990 | 5 | 5 | 5 | 5 | 5 | 5 |
| Conversion (%) after irradiation of 10 seconds | 63 | 70 | 87 | 20 | 24 | 13 |
| after irradiation of 30 seconds | 82 | 83 | 91 | 46 | 40 | 29 |
| Pencil scratch value | 3H | 3H | 3H | 3H | 3H | 3H |

In the Examples and Comparative Examples of each Table, compounds shown below were used.

| | |
|---|---|
| EPIKOTE 828: | bisphenol A-type epoxy resin, produced by Yuka Shell Epoxy K.K. |
| XDO: | 1,4-bis[(3-ethyl-3-oxetanylmethoxy)methyl]benzene, produced by Toa Gosei |
| EPIKOTE 152: | phenol·novolak type epoxy resin, produced by Yuka Shell Epoxy K.K. |
| KRM-2110: | alicyclic base resin, produced by Asahi Denka Kogyo K.K. |
| SUN-AID SI-60L:$SbF_6^-$ | type sulfonium salt cationic polymerization initiator, produced by Sanshin Kagaku Kogyo K.K. |
| UVI-6990: | triaryl sulfonium hexafluorophosphate salt-type cationic polymerization initiator, produced by UCC. |

Industrial Applicability

The present invention provides a cationic polymerizable composition exhibiting high activity (rapid curability) under heat and/or under irradiation of an active energy ray and also provides a cured material thereof and a method for producing the cured material. The present invention can be applied to the coating on paper or plastic having poor heat resistance and further can be applied to a coating, an adhesive, a sealing agent, a construction and building material, a laminate, electrical and electronic parts, a photoresist, a solder resist, a layer insulating film for multilayer circuit boards, concrete structure repairing, or a material for cast molding, a printing ink, a sealant, and a material for stereolithography.

It will be appreciated by those skilled in the art that while the invention has been described above in connection with particular embodiments and examples, the invention is not necessarily so limited and that numerous other embodiments, examples, uses, modifications and departures from the embodiments, examples and use may be made without departing from the inventive scope of this application.

## Claims

1. A polymerizable composition comprising (a) a compound represented by formula (1):

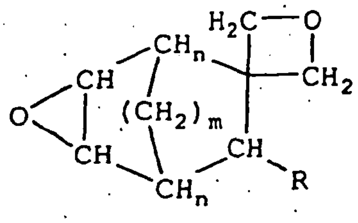

(1)

wherein R represents a hydrogen atom or a methyl group, m represents an integer of 0 to 2, and n is 2 when m is 0 and otherwise n is 1, and (b) a compound capable of generating an acid under irradiation of an active energy ray and/or under heat, and thereby initiating the cationic polymerization, wherein said compound (b) is one or more compound selected from the group consisting of sulfonium salts, iodonium salts and diazonium salts.

2. The polymerizable composition according to claim 1, wherein said alicyclic alkane (a) is 7,8-epoxy-2-oxa-5-methylspiro[-3--5]nonane.

3. The polymerizable composition according to claim 1, which comprises a compound (c) that can be cationic polymerized by said compound (b), wherein said compound (c) is other than said compound (a).

4. The polymerizable composition according to claim 3, wherein at least one of said compounds (c) is a _ compound (c-1) having one or more epoxy group that can be cationic polymerized by said compound (b).

5. The polymerizable composition according to claim 3, wherein at least one of said compounds (c) is a compound (c-2) having one or more oxetanyl group that can be cationic polymerized by said compound (b).

6. The polymerizable composition according to claim 1, wherein said alicyclic alkane (a) is blended in an amount of 5 to 100 mass % based on the total mass of the polymerizable composition minus the mass of said compound (b).

7. The polymerizable composition according to claim 4 wherein said compound (c-1) is blended in an amount of 5 to 95 mass % based on the total mass of the polymerizable composition minus the mass of said compound (b).

**8.** The polymerizable composition according to claim 5, wherein said compound (c-2) is blended in an amount of 5 to 95 mass % based on the total mass of the polymerizable composition minus the mass of said compound

**9.** A cured material obtained by polymerizing a polymerizable composition comprising (a) a compound represented by formula (1):

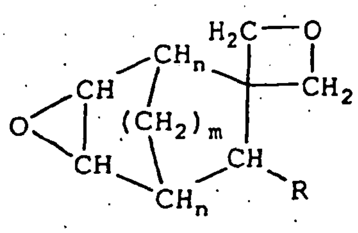

(1)

wherein R represents a hydrogen atom or a methyl group, m represents an integer of 0 to 2, and n is 2 when m is 0 and otherwise n is 1, and (b) a compound capable of generating an acid under irradiation of an active energy ray and/or under heat, and thereby initiating the cationic polymerization, wherein said compound (b) is one or more compound selected from the group consisting of sulfonium salts, iodonium salts and diazonium salts under irradiation of an active energy ray and/or under heat.

**10.** The cured material according to claim 9 wherein said alicyclic alkane (a) is 7,8-epoxy-2-oxa-5-methylspiro[3.5] nonane.

**11.** The cured material according to claim 10, which comprises a compound (c) that can be cationic polymerized by said compound (b), wherein said compound (c) is other than said compound (a).

**12.** The cured material according to claim 11, wherein at least one of said compound (c) is a compound (c-1) having one or more epoxy group that can be cationic polymerized by said compound (b).

**13.** The cured material according to claim 11, wherein at least one of said compound (c) is a compound (c-2) having one or more oxetanyl group that can be cationic polymerized by said compound (b).

**14.** The cured material according to claim 9, wherein said alicyclic alkane (a) is blended in an amount of 5 to 100 mass% based on the total mass of the polymerizable composition minus the mass of said compound (b).

**15.** The cured material according to claim 12 wherein said compound (c-1) is blended in an amount of 5 to 95 mass % based on the total mass of the polymerizable composition minus the mass of said compound (b).

**16.** The cured material according to claim 13, wherein said compound (c-2) is blended in an amount of 5 to 95 mass % based on the total mass of the polymerizable composition minus the mass of said compound (b).

**17.** A method for manufacturing a cured material from a polymerizable composition comprising (a) a compound represented by formula (1):

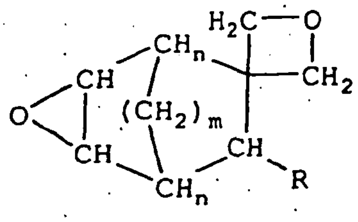

(1)

wherein R represents a hydrogen atom or a methyl group, m represents an integer of 0 to 2, and n is 2 when m is 0 and otherwise n is 1, and (b) a compound capable of generating an acid under irradiation of an active energy ray and/or under heat, and thereby initiating the cationic polymerization, wherein said compound (b) is one or more compound selected from the group consisting of sulfonium salts, iodonium salts and diazonium salts under irradiation

of the active energy ray and/or under heat, said method comprising initiating the polymerization under irradiation of an active energy ray and/or under heat.

**18.** The method for manufacturing the cured material according claim 17, comprising initiating the polymerization under irradiation of an active energy ray.

**19.** The method according to claim 18, wherein said active ray is ultraviolet light.

**20.** The method for manufacturing the cured material according to claim 17, comprising initiating the polymerization under heat.

**21.** The method for manufacturing the cured material according to claim 17 comprising initiating the polymerization under irradiation of an active energy ray and then heating the composition.

**22.** The method according to claim 21, wherein said active ray is ultraviolet light.

**Patentansprüche**

**1.** Polymerisierbare Zusammensetzung, die (a) eine Verbindung der Formel (1)

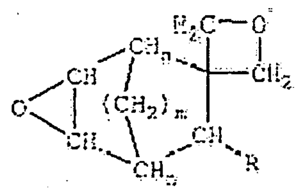

(1)

worin R ein Wasserstoffatom oder eine Methylgruppe darstellt, m eine ganze Zahl von 0 bis 2 darstellt und n 2 ist, wenn m 0 ist, und n ansonsten 1 ist,
und (b) eine Verbindung umfaßt, die unter Bestrahlung mit Aktivenergiestrahlen und/oder unter Hitze eine Säure erzeugen kann und **dadurch** die kationische Polymerisation initiieren kann, worin die Verbindung (b) eine oder mehrere Verbindungen ist, die aus der Gruppe ausgewählt sind, die aus Sulfoniumsalzen, Iodoniumsalzen und Diazoniumsalzen besteht.

**2.** Polymerisierbare Zusammensetzung nach Anspruch 1, worin das alicyclische Alkan (a) 7,8-Epoxy-2-oxa-5-methyl-spiro[3.5]nonan ist.

**3.** Polymerisierbare Zusammensetzung nach Anspruch 1, welche eine Verbindung (c) enthält, die durch die Verbindung (b) kationisch polymerisiert werden kann, wobei die Verbindung (c) eine andere als die Verbindung (a) ist.

**4.** Polymerisierbare Zusammensetzung nach Anspruch 3, worin mindestens eine der Komponenten (c) eine Verbindung (c-1) mit einer oder mehreren Epoxygruppen ist, die durch die Verbindung (b) kationisch polymerisiert werden können.

**5.** Polymerisierbare Zusammensetzung nach Anspruch 3, worin mindestens eine der Verbindungen (c) eine Verbindung (c-2) mit einer oder mehreren Oxetanylgruppen ist, die durch die Verbindung (b) kationisch polymerisiert werden können.

**6.** Polymerisierbare Zusammensetzung nach Anspruch 1, worin das alicyclische Alkan (a) in einer Menge von 5 bis 100 Massen-%, bezogen auf die Gesamtmasse der polymerisierbaren Zusammensetzung abzüglich der Masse der Verbindung (b), zugemischt ist.

**7.** Polymerisierbare Zusammensetzung nach Anspruch 4, worin die Verbindung (c-1) in einer Menge von 5 bis 95 Massen-%, bezogen auf die Gesamtmasse der polymerisierbaren Zusammensetzung abzüglich der Masse der Verbindung (b), zugemischt ist.

**8.** Polymerisierbare Zusammensetzung nach Anspruch 5, worin die Verbindung (c-2) in einer Menge von 5 bis 95 Massen-%, bezogen auf die Gesamtmasse der polymerisierbaren Zusammensetzung abzüglich der Masse der Verbindung (b), zugemischt ist.

**9.** Gehärtetes Material, erhalten durch Polymerisieren einer polymerisierbaren Zusammensetzung, die (a) eine Verbindung der Formel (1)

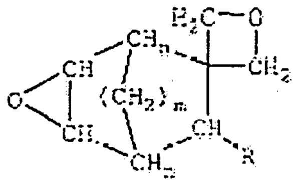

(1)

worin R ein Wasserstoffatom oder eine Methylgruppe darstellt, m eine ganze Zahl von 0 bis 2 darstellt und n 2 ist, wenn m 0 ist, und n ansonsten 1 ist, und (b) eine Verbindung umfaßt, die unter Bestrahlung mit Aktivenergiestrahlen und/oder unter Hitze eine Säure erzeugen kann und **dadurch** die kationische Polymerisation initiieren kann, unter Bestrahlen mit Aktivenergiestrahlen und/oder unter Erhitzen, wobei die Verbindung (b) eine oder mehrere Verbindungen ist, die aus der Gruppe ausgewählt sind, die aus Sulfoniumsalzen, Iodoniumsalzen und Diazoniumsalzen besteht.

**10.** Gehärtetes Material nach Anspruch 9, wobei das alicyclische Alkan (a) 7,8-Epoxy-2-oxa-5-methyl-spiro[3.5]nonan ist.

**11.** Gehärtetes Material nach Anspruch 10, welches eine Verbindung (c) enthält, die durch die Verbindung (b) kationisch polymerisiert werden kann, wobei die Verbindung (c) eine andere als die Verbindung (a) ist.

**12.** Gehärtetes Material nach Anspruch 11, worin mindestens eine der Komponenten (c) eine Verbindung (c-1) mit einer oder mehreren Epoxygruppen ist, die durch die Verbindung (b) kationisch polymerisiert werden können.

**13.** Gehärtetes Material nach Anspruch 11, worin mindestens eine der Verbindungen (c) eine Verbindung (c-2) mit einer oder mehreren Oxetanylgruppen ist, die durch die Verbindung (b) kationisch polymerisiert werden können.

**14.** Gehärtetes Material nach Anspruch 9, worin das alicyclische Alkan (a) in einer Menge von 5 bis 100 Massen-%, bezogen auf die Gesamtmasse der polymerisierbaren Zusammensetzung abzüglich der Masse der Verbindung (b), zugemischt ist.

**15.** Gehärtetes Material nach Anspruch 12, worin die Verbindung (c-1) in einer Menge von 5 bis 95 Massen-%, bezogen auf die Gesamtmasse der polymerisierbaren Zusammensetzung abzüglich der Masse der Verbindung (b), zugemischt ist.

**16.** Gehärtetes Material nach Anspruch 13, worin die Verbindung (c-2) in einer Menge von 5 bis 95 Massen-%, bezogen auf die Gesamtmasse der polymerisierbaren Zusammensetzung abzüglich der Masse der Verbindung (b), zugemischt ist.

**17.** Verfahren zur Herstellung eines gehärteten Materials aus einer polymerisierbaren Zusammensetzung, die (a) (a) eine Verbindung der Formel (1)

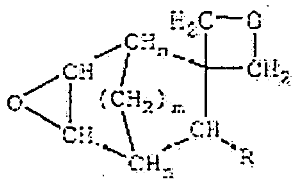

(1)

worin R ein Wasserstoffatom oder eine Methylgruppe darstellt, m eine ganze Zahl von 0 bis 2 darstellt und n 2 ist, wenn m 0 ist, und n ansonsten 1 ist,
und (b) eine Verbindung umfaßt, die unter Bestrahlung mit Aktivenergiestrahlen und/oder unter Hitze eine Säure erzeugen kann und **dadurch** die kationische Polymerisation initiieren kann, worin die Verbindung (b) eine oder mehrere Verbindungen ist, die aus der Gruppe ausgewählt sind, die aus Sulfoniumsalze, Iodoniumsalzen und Diazoniumsalzen besteht, unter Bestrahlen mit den Aktivenergiestrahlen und/oder unter Erhitzen, wobei das Verfahren das Initiieren der Polymerisation unter Bestrahlung mit Aktivenergiestrahlen und/oder Erhitzen umfaßt.

**18.** Verfahren zum Herstellen des gehärteten Materials nach Anspruch 17, welches das Initiieren der Polymerisation unter Bestrahlung mit Aktivenergiestrahlen umfaßt.

**19.** Verfahren nach Anspruch 18, wobei die aktiven Strahlen UV-Licht sind.

**20.** Verfahren zum Herstellen des gehärteten Materials nach Anspruch 17, welches das Initiieren der Polymerisation unter Erhitzen umfaßt.

**21.** Verfahren zum Herstellen des gehärteten Materials nach Anspruch 17, welches das Initiieren der Polymerisation unter Bestrahlung mit Aktivenergiestrahlen und anschließendem Erhitzen der Zusammensetzung umfaßt.

**22.** Verfahren nach Anspruch 21, wobei die aktiven Strahlen UV-Licht sind.

## Revendications

**1.** Composition polymérisable comprenant (a) un composé représenté par la formule (1) :

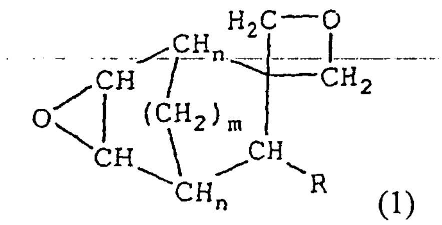

(1)

dans laquelle R représente un atome d'hydrogène ou un groupe méthyle, m représente un entier de 0 à 2, et n est 2 quand m est 0 ou autrement n est 1,
et (b) un composé capable de générer un acide sous irradiation d'un rayon d'énergie actif et/ou à la chaleur et d'initier ainsi la polymérisation cationique,
où ledit composé (b) est un composé, ou plus, sélectionné dans le groupe constitué des sels de sulfonium, des sels d'iodonium et des sels de diazonium.

**2.** Composition polymérisable selon la revendication 1, dans laquelle ledit alcane alicyclique (a) est le 7,8-époxy-2-oxa-5-méthylspiro[3.5]nonane.

**3.** Composition polymérisable selon la revendication 1, qui comprend un composé (c) qui peut être polymérisé cationiquement par ledit composé (b), dans lequel ledit composé (c) est autre que ledit composé (a).

**4.** Composition polymérisable selon la revendication 3, dans laquelle au moins un desdits composés (c) est un composé (c-1) ayant un groupe époxy, ou plus, qui peut être cationiquement polymérisé par ledit composé (b).

**5.** Composition polymérisable selon la revendication 3, dans laquelle au moins un desdits composés (c) est un composé (c-2) ayant un groupe oxétanyle, ou plus, qui peut être cationiquement polymérisé par ledit composé (b).

**6.** Composition polymérisable selon la revendication 1, dans laquelle ledit alcane alicyclique (a) est mélangé en une quantité de 5 à 100 % en poids sur la base du poids total de la composition polymérisable moins le poids dudit composé (b).

**7.** Composition polymérisable selon la revendication 4, dans laquelle ledit composé (c-1) est mélangé en une quantité de 5 à 95 % en poids sur la base du poids total de la composition polymérisable moins le poids dudit composé (b).

**8.** Composition polymérisable selon la revendication 5, dans laquelle ledit composé (c-2) est mélangé en une quantité de 5 à 95 % en poids sur la base du poids total de la composition polymérisable moins le poids dudit composé (b).

**9.** Matériau durci obtenu par polymérisation d'une composition polymérisable comprenant (a) un composé représenté par la formule (1) :

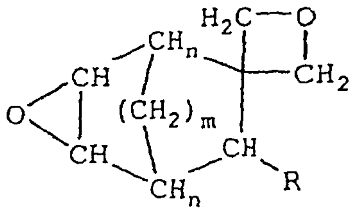

(1)

dans laquelle R représente un atome d'hydrogène ou un groupe méthyle, m représente un entier de 0 à 2, et n est 2 quand m est 0 ou autrement n est 1,
et (b) un composé capable de générer un acide sous irradiation d'un rayon d'énergie actif et/ou à la chaleur et d'initier ainsi la polymérisation cationique,
où ledit composé (b) est un composé, ou plus, sélectionné dans le groupe constitué des sels de sulfonium, des sels d'iodonium et des sels de diazonium sous irradiation d'un rayon d'énergie actif et/ou à la chaleur.

**10.** Matériau durci selon la revendication 9, dans lequel ledit alcane alicyclique (a) est le 7,8-époxy-2-oxa-5-méthylspiro [3.5]nonane.

**11.** Matériau durci selon la revendication 10, qui comprend un composé (c) qui peut être polymérisé cationiquement par ledit composé (b), dans lequel ledit composé (c) est autre que ledit composé (a).

**12.** Matériau durci selon la revendication 11, dans lequel au moins un desdits composés (c) est un composé (c-1) ayant un groupe époxy, ou plus, qui peut être cationiquement polymérisé par ledit composé (b).

**13.** Matériau durci selon la revendication 11, dans lequel au moins un desdits composés (c) est un composé (c-2) ayant un groupe oxétanyle, ou plus, qui-peut- être cationiquement polymérisé par ledit composé (b).

**14.** Matériau durci selon la revendication 9, dans lequel ledit alcane alicyclique (a) est mélangé en une quantité de 5 à 100 % en poids sur la base du poids total de la composition polymérisable moins le poids dudit composé (b).

**15.** Matériau durci selon la revendication 12, dans lequel ledit composé (c-1) est mélangé en une quantité de 5 à 95 % en poids sur la base du poids total de la composition polymérisable moins le poids dudit composé (b).

**16.** Matériau durci selon la revendication 13, dans laquelle ledit composé (c-2) est mélangé en une quantité de 5 à 95 % en poids sur la base du poids total de la composition polymérisable moins le poids dudit composé (b).

**17.** Procédé de fabrication d'un matériau durci à partir d'une composition polymérisable comprenant (a) un composé représenté par la formule (1):

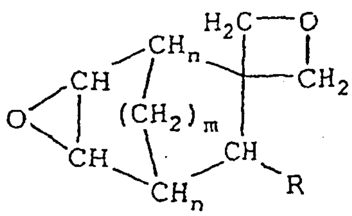

(1)

dans laquelle R représente un atome d'hydrogène ou un groupe méthyle, m représente un entier de 0 à 2, et n est 2 quand m est 0 ou autrement n est 1,
et (b) un composé capable de générer un acide sous irradiation d'un rayon d'énergie actif et/ou à la chaleur et d'initier ainsi la polymérisation cationique,
où ledit composé (b) est un composé, ou plus, sélectionné dans le groupe constitué des sels de sulfonium, des sels d'iodonium et des sels de diazonium, sous irradiation d'un rayon d'énergie actif et/ou à la chaleur, ledit procédé comprenant l'initiation de la polymérisation sous irradiation d'un rayon d'énergie actif et/ou à la chaleur.

**18.** Procédé de fabrication du matériau durci selon la revendication 17, comprenant l'initiation de la polymérisation sous irradiation d'un rayon d'énergie actif.

**19.** Procédé selon la revendication 18, dans lequel ledit rayon actif est la lumière ultraviolette.

**20.** Procédé de fabrication du matériau durci selon la revendication 17 comprenant l'initiation à la chaleur.

**21.** Procédé de fabrication du matériau durci selon la revendication 17, comprenant l'initiation de la polymérisation sous irradiation d'un rayon d'énergie actif et puis chauffage de la composition.

**22.** Procédé selon la revendication 21, dans lequel ledit rayon actif est la lumière ultraviolette.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6016804 A
- JP 11246541 A
- JP 11106380 A
- JP 11061034 A
- US 3457193 A
- GB 2310211 A
- US 3388105 A


### Non-patent literature cited in the description


- *Journal of Macromolecular Science,* 1992, vol. A 29 (10), 915
- *JOURNAL OF MACROMOLECULAR SCIENCE,* vol. 30 (2 & 3), 173
- *JOURNAL OF MACROMOLECULAR SCIENCE,* 1993, vol. 30 (2 & 3), 189